# EUROPÄISCHE PATENTSCHRIFT

(11) **EP 1 324 386 B1**
(45) Veröffentlichungstag und Bekanntmachung des Hinweises auf die Patenterteilung: **15.06.2011**
(21) Anmeldenummer: 01811271.4
(22) Anmeldetag: 24.12.2001
(51) Int. Cl.: H01L 23/13, H01L 23/498, H01L 21/48, H01L 25/07

(54) **Halbleitermodul und Verfahren zum Herstellen eines Halbleitermoduls**
Semiconductor module and method of manufacturing a semiconductor module
Module semi-conductreur et méthode de fabrication d'un module semi-conducteur

(43) Veröffentlichungstag der Anmeldung: 02.07.2003
(73) Patentinhaber: ABB Research Ltd., 8050 Zürich (CH)
(72) Erfinder: Knapp, Wolfgang, 5430 Wettingen (CH)
(74) Vertreter: ABB Patent Attorneys

(56) Entgegenhaltungen:
- EP-A- 0 661 748
- EP-A- 0 921 565
- DE-A- 19 527 611
- GB-A- 2 196 178
- US-A- 5 529 959
- US-A- 5 532 517
- US-A- 5 789 270

## Beschreibung

### Technisches Gebiet

Die Erfindung bezieht sich auf das Gebiet der Leistungselektronik. Sie betrifft ein Halbleitermodul gemäss dem Oberbegriff des Patentanspruchs 1 sowie ein Verfahren zum Herstellen eines Halbleitermoduls gemäss dem Oberbegriff des Patentanspruchs 6.

### Stand der Technik

Ein derartiges Halbleitermodul ist beispielsweise aus R. Zehringer et al., "Power Semiconductor Materials and Devices", Materials Research Society Symposium Proceedings, Volume 483, 1998, S. 369-380, bekannt. Diese Publikation beschreibt ein Halbleitermodul mit einem Modulgehäuse, einer metallenen Basisplatte und mehreren darauf angeordneten, vom Modulgehäuse überdeckten Halbleiterelementen, in diesem Fall IGBT-Chips (Insulated Gate Bipolar Transistor) und Dioden. Das Modulgehäuse ist im allgemeinen mit einer Silikon-Gelmasse ausgefüllt, welche als elektrische Isolationsschicht und als Korrosionsschutz dient sowie auf Verbindungsdrähte wirkende Zugkräfte vermindert. Die Basisplatte ist mit einer Wasserkühlung verbunden, um die von den Halbleiterelementen erzeugte Wärme abzuführen. Auf der Basisplatte ist ein Substrat in Form einer metallbeschichteten Keramikplatte angeordnet. Sie bildet eine elektrische Isolation zwischen Halbleiterelemente und Basisplatte beziehungsweise Wasserkühlung und weist zudem eine gute Wärmeleitfähigkeit auf, um die Wärme der Halbleiterelemente zur Basisplatte abzuführen. Basisplatte, Keramikplatte und Halbleiterelemente sind aufeinander gelötet, wobei die Metallschichten der Keramikplatte die Lötverbindung ermöglichen.

Gute Wärmeleitfähigkeit und schlechte elektrische Leitfähigkeit lassen sich heute in Materialien kombinieren, so dass es keine Schwierigkeiten bereitet, relativ dünne, jedoch gut wärmeleitende Isolationselemente, beispielsweise aus Aluminiumnitrid (AIN), mit einer guten elektrischen Isolierfähigkeit herzustellen. So reicht theoretisch eine Dicke von 1.5 bis 2 mm aus, um 20kV zu isolieren.

Randeffekte, insbesondere verursacht durch Kanten und Ecken der Metallschichten, wirken sich jedoch nachteilig auf die Spannungsfestigkeit des Halbleitermoduls aus, insbesondere bei Hochleistungshalbleitermodulen oberhalb von 1.2 kV. Die Kanten und Ecken der Metallschichten weisen ein inhomogenes, verstärktes elektrisches Feld auf. Diese Feldüberhöhung führt zu Teilentladungen und begrenzt die Spannungsfestigkeit des gesamten Aufbaus. Dabei verhält sich die Feldstärke an den Rändern mindestens quadratisch zur Spannung, so dass zur Vermeidung derartiger Teilentladungen eine massiv dickere elektrische Isolierung notwendig wäre. Luftbläschen, welche beim Einfallen von Gel in das Modulgehäuse gerade in den Randzonen entstehen können, begünstigen Teilentladungen und bilden einen zusätzlichen kritischen Faktor bezüglich der Funktionsfähigkeit des Halbleitermoduls.

Es gibt verschiedene Lösungsansätze, um dem Isolationsproblem beizukommen. In DE 189 59 248 sind in feld-kritischen Bereichen Aussparungen ausgebildet, welche mit Gel ausgefüllt werden und somit eine zusätzliche Grenzfläche bildet, welche die Ausbreitung von Entladungen verhindert. In EP 1 041 626 wird das Feld in kritischen Bereichen durch dreidimensionale Rundungen im Substrat reduziert. Beide Lösungen sind aufwendig und teuer in der Herstellung.

In EP 0 921 565 ist ein Halbleitermodul gezeigt, bei welchem Halbleiterelemente auf einer Metallisierung angeordnet sind. Die Metallisierung wiederum ist auf einem isolierenden Substrat angeordnet. Im Randbereich der Metallisierung, auf welcher die Halbleiterelemente angeordnet sind, wird ein Isoliermaterial aufgebracht, welches die Metallisierung überdeckt, so dass die Kante der Metallisierung in das Isoliermaterial eingebettet ist.

### Kurze Darstellung der Erfindung

Es ist daher Aufgabe der Erfindung, ein Halbleitermodul der eingangs genannten Art zu schaffen, welches eine verbesserte Spannungsfestigkeit aufweist und gleichzeitig einfach herstellbar ist. Weiter ist es Aufgabe der Erfindung ein vereinfachtes und zuverlässigeres Verfahren zum Herstellen eines Halbleitermoduls der eingangs genannten Art zu schaffen.

Die Aufgaben werden durch ein Halbleitermodul mit den Merkmalen des Patentanspruchs 1 sowie durch ein Verfahren mit den Merkmalen des Patentanspruchs 6 gelöst.

Das erfindungsgemässe Halbleitermodul mit einem Basiselement, mindestens einem Isolationselement, welches mit einer ersten von zwei auf gegenüberliegenden Oberflächen des Isolationselements angeordneten Metallisierungen auf dem Basiselement aufliegt, mit mindestens einem auf der zweiten der zwei Metallisierungen angeordneten Halbleiterelement, zeichnet sich dadurch aus, dass im Randbereich des Isolationselements eine elektrisch isolierende Schicht angeordnet ist, und dass die Oberfläche der Isolierschicht mit der Oberfläche der zweiten Metallisierung eine gemeinsame plane Oberfläche bildet.

Das Entschärfen der Kanten und Ecken der Metallisierung durch ebenes Einbetten des ganzen metallisierten Isolationselements verbessert die Isolationseigenschaft des Halbleitermoduls im Bereich der kritischen elektrischen Feldregion. Gegenüber herkömmlichen, mit Silikon-Gel aufgefüllten Halbleitermodulen ergibt sich eine erhebliche Verbesserung bezüglich der elektrischen Isolation, wobei die Vorteile des flachen, metallisierten Isolationselements, insbesondere die gute thermische Leitfähigkeit sowie die tiefen Herstellungskosten, erhalten bleiben.

Zum Kontaktieren der Halbleiterelemente sind Kontaktierungselementen in die Isolierschicht eingelassen, wobei die Kontaktierungselemente durch die Isolierschicht sowohl von der zweiten Metalliesierung als auch von dem Basiselement elektrisch isoliert sind. Die Kontaktierungselemente weisen Kontaktierflächen auf, welche mit den Oberflächen der Isolierschicht und der zweiten Metallisierung eine gemeinsame plane Oberfläche bilden.

Dass alle anderen wesentlichen Teile des Halbleitermoduls eine gemeinsame plane Oberfläche bilden, vereinfacht die Bearbeitung und das Aufbringen der Halbleiterelemente.

In einer zweiten Ausführungsform des erfindungsgemässen Halbleitermoduls ist in die Oberfläche des Basiselements eine Vertiefung eingelassen, in welcher das Isoliationselement angeordnet ist. Die zweite Metallisierung des Isolationselements ist von dem Basiselement durch die Isolierschicht elektrisch isoliert. Die Oberflächen des Isolationselements, der zweiten Metallisierung und des Basiselements bilden eine gemeinsame plane Oberfläche.

In dieser Ausführungsform können Halbleiterelemente oder andere elektronische Bauteile nebeneinander und voneinander elektrisch isoliert sowohl auf der zweiten Metallisierung als auch auf dem Basiselement selber angeordnet werden. Insbesondere in sogenannten Press-Pack Modulen, in welchen zweiseitig kontaktierbare Halbleiterelemente über einen Kontaktstempel kontaktiert und mit Anpresskraft beaufschlagt werden, ergeben sich dadurch interessante Möglichkeiten. So können beispielsweise zwei nebeneinander angeordnete Halbleiterelemente elektrisch in Serie geschaltet werden, ohne dass die Geometrie der jeweiligen Kontaktstempel angepasst werden müsste.

Für die Press-Pack Module ergibt sich durch die gemeinsame Oberfläche der zweiten Metallisierung des Isolationselements und der Isolierschicht die Einsparung eines Verfahrensschritts in der Herstellung. Da herkömmliche Standard-Substrate, welche als Isolationselement vorzugsweise verwendet werden, den Anforderungen an die Flachheit für den Einsatz in einem Press-Pack Modul nicht genügen, müssen diese maschinell behandelt werden, beispielsweise durch Fräsen. Das Präzisionsfräsen kann bei der Herstellung des erfindungsgemässen Halbleitermoduls mit dem Abfräsen der Isolierschicht und dem Aufbereiten der Kontaktierflächen verbunden und in einem Schritt durchgeführt werden.

Beim erfindungsgemässen Verfahren zu Verfahren zum Herstellen eines Halbleitermoduls wird mindestens ein Isolationselement mit einer ersten von zwei auf gegenüberliegenden Oberflächen des Isolationselements angeordneten Metallisierungen auf einem Basiselement oder in einer Oberflächenvertiefung des Basiselements befestigt. Halbleiterelemente werden auf der zweiten Metallisierung und/oder, falls das Isolationselement in einer Vertiefung angeordnet ist, auf der Oberfläche des Basiselements befestigt und Haupt- und/ oder Steueranschlüsse der Halbleiterelemente werden mit Drahtverbindungen oder anderen elektrischen Leitern kontaktiert und mit Kontaktierungsflächen von Kontaktierungselementen verbunden.

Gekennzeichnet ist das erfindungsgemässe Halbleitermodul dadurch, dass bevor die Halbleiterelemente befestigt werden, das Basiselement und das mindestens eine Isolationselement zusammen mit den Kontaktierungselementen in eine Gussform gebracht werden, eine Isolierschicht durch Ausfüllen des nicht durch Basiselement, Isolationselement oder Kontaktierungselement beanspruchten Volumens der Gussform mit einem elektrisch isolierenden Material geformt wird und dass anschliessend die Isolierschicht gehärtet und von der gehärteten Isolierschicht soviel Material abgetragen wird, dass die Oberfläche der Isolierschicht mit der Oberfläche der zweiten der zwei Metallisierung, mit Kontaktierungsflächen der Kontaktierungselemente sowie, falls das Isolationselement in einer Vertiefung angeordnet ist, mit der Oberfläche des Basiselements eine gemeinsame plane Oberfläche bildet; und dass nachdem die Halbleiterelemente befestigt worden sind, bewegliche Kontaktierungsstücke der Kontaktierungselemente senkrecht zur Oberfläche der Isolierschicht aufgerichtet werden.

Das Aufbringen der Isolierschicht und das entsprechende Abtragen auf die gemeinsame Oberfläche bevor die Halbleiterelemente befestigt werden, ermöglicht ein Testen des gesamten Halbleitermoduls bezüglich der elektrischen Isolationsfestigkeit bevor die Halbleiterelemente in einem aufwendigen und kostenintensiven Verfahrensschritt befestigt und kontaktiert werden. Die Zahl der fertig bestückten Halbleitermodule mit fehlerhafter Isolation lässt sich dadurch wesentlich reduzieren.

In einem zusätzlichen vorteilhaften Schritt des erfindungsgemässen Verfahrens kann die Gussform vor dem Auffüllen mit dem elektrisch isolierenden Material zumindest teilweise evakuiert werden. Dadurch verbessert sich die Struktur der Isolierschicht, insbesondere kann die Bildung von Luftbläschen, welche elektrische Entladungen begünstigen können, vermieden werden.

### Kurze Beschreibung der Zeichnungen

Anschliessend wird die Erfindung anhand von bevorzugten Ausführungsbeispielen in Verbindung mit den Zeichnungen näher erläutert. Es zeigen:
- Fig. 1: eine vereinfachte Schnittansicht eines ersten Ausführungsbeispiels eines erfindungsgemässen Halbleitermoduls vor dem Einbringen des Moduls in eine Gussform zum Anbringen einer Isolierschicht,
- Fig. 2: das Halbleitermodul gemäss Fig. 1 in der Gussform beim Anbringen der Isolierschicht,
- Fig. 3: das Halbleitermodul gemäss Fig. 2 mit angebrachter Isolierschicht,
- Fig. 4: das montagebereite Halbleitermodul gemäss Fig. 3, und
- Fig. 5: eine vereinfachte Schnittansicht eines zweiten Ausführungsbeispiels eines erfindungsgemässen Halbleitermoduls.

In allen Figuren beziehen sich gleichlautende Bezugszeichen auf gleichwirkende Teile.

### Weg zur Ausführung der Erfindung

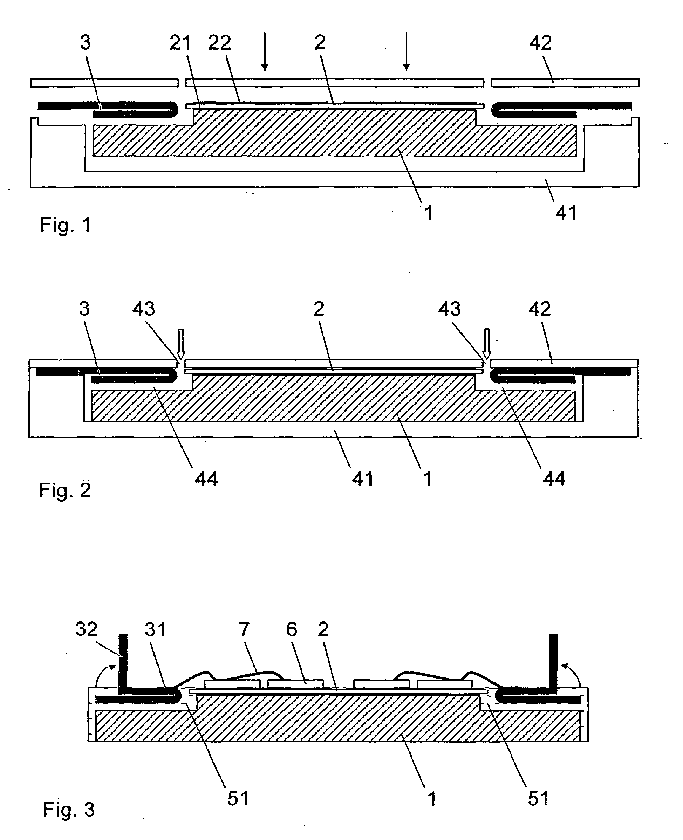

Anhand der Fig. 1 bis 4, welche ein erstes Ausführungsbeispiel eines erfindungsgemässen Halbleitermoduls zeigen, wird das erfindungsgemässe Herstellungsverfahren erläutert.

In einem ersten Verfahrensschritt wird auf einem Basiselement 1 ein Isolationselement 2 befestigt. Beim Isolationselement handelt es sich vorteilhafterweise um ein zweiseitig metallisiertes Substrat, welches beispielsweise eine mit Kupfer- oder Aluminium-Metallisierung versehene AlO₃-, oder AIN-Keramikplatte umfasst. Das Material des Basiselement, beispielsweise Mo, AISiC oder Aluminium- oder Kupfergrafit, ist bezüglich thermischer Ausdehnung vorteilhafterweise dem Material des Isolationselements angepasst. Das Isolationselement 2 ist mit einer ersten Metallisierung 21 direkt auf dem Basiselement befestigt, beispielsweise mittels einer Löt- oder einer sogenannten Nieder-Temperatur-Verbindung (LTB, Low Temperature Bonding). Die zweite Metallisierung 22 kann mehrere voneinander elektrisch isolierte Bereiche umfassen.

In dafür vorgesehenen Ausnehmungen des Basiselements 1 werden Kontaktierungselemente 3 zum Kontaktieren der Halbleiterelemente angebracht. Dazu werden Basiselement 1, Isolationselement 2 und die Kontaktierungselemente 3 in eine wannenförmige Gussform 41 gebracht, wie in Fig. 1 dargestellt. Die Kontaktierungselemente 3 werden dabei durch entsprechende Führungselemente relativ zum Basiselement 1 positioniert und ausgerichtet. Die Gussform 41 wird mit einem zweiten Gussformteil 42 geschlossen.

In Fig. 2 wird anschliessend durch in die Gussform eingelasse Öffnungen 43 ein elektrisch isolierendes Material 51 in einen Hohlraum 44 im Inneren der Gussform gegossen (Pfeile). Der Hohlraum 44 entspricht dem nicht durch Basiselement 1, Isolationselement 2 und Kontaktierungselemente 3 ausgefüllten Innenvolumen der Gussform. Hauptsächlich erstreckt sich der Hohlraum 44 jedoch auf einen Bereich zwischen den Kontaktierungselementen 3 und dem Basiselement 1. Beim Material dieser auf diese Weise erzeugten elektrisch isolierenden Schicht 51 handelt es sich vorteilhafterweise um einen gut fliessenden Kunststoff, der gut aushärtet und im gehärteten Zustand für kurze Zeit auf über 220° C erhitzbar ist, ohne sich gross zu deformieren. Dies ist insbesondere bei denjenigen Halbleitermodulen wichtig, bei welchen Halbleiterelemente auf die Metallisierung des Isolationselementes aufgelötet werden. Weiter sollte der Kunststoff einen Wärmeausdehnungskoeffizienten haben, welcher dem der umliegenden Materialien entspricht. Entsprechende Kunststoffe sind beispielsweise unter den Handelsnamen Stycast oder Aratherm erhältliche Epoxide. Diese Stoffe liegen mit der Duchbruchspannung etwa im Bereich des in herkömmlichen Halbleitermodulen verwendeten Silicongels, weisen jedoch eine erheblich verbesserte Adhäsion und eine das elektrische Feld entsprechend reduzierende höhere Dielektrizitätskonstante auf. Für Halbleitermodule ohne angelötete Halbleiterelemente, beispielsweise in Press-Pack-Modulen, können auch kostengüstigere Materialien verwendet werden, beispielsweise giessbare Polyurethane, welche für Isolationen im Innenbereich im grossen Stil verwendet werden. Für Anwendungen ohne hohe Anforderungen an die mechanische Steifheit, kann Silikongummi verwendet werden. Dieser erträgt weit höhere Temperaturen und haftet zudem, insbesondere in Kombination mit sogenannten Primers, ausgezeichnet an den meisten Materialen. Zur Reduktion des Ausdehnungskoeffizienten und zur Erhöhung der thermischen Leitfähigkeit werden dem Material der Isolierschicht bis zu mehr als 50% der Gussmasse Giessharz-Füllstoffe beigemischt.

Um den Giessvorgang zu erleichtern und insbesondere die Homogenität der Isolierschicht 51 zu gewährleisten, wird die Gussform vor dem Giessen vorteilhafterweise evakuiert. Dabei wird die Luft aus dem Innern der Gussform duch die Öffnungen 43 oder andere, speziell dafür vorgesehene Öffnungen gesaugt. Durch die Verarbeitung unter Vakuum kann die Bildung von Luftbläschen im Innern der Isolierschicht 51 verhindert werden. Luftbläschen können die Entstehung von Entladungen begünstigen.

Im Anschluss an den Giessvorgang wird das Halbleitermodul aus der Giessform entfernt. Die Isolierschicht 51 ist soweit gehärtet, dass sie mechanisch bearbeitet werden kann. In einem Arbeitsschritt wird die Isolierschicht 51 auf eine gemeinsame Fläche mit der Oberfläche der zweiten Metallisierung 22 abgetragen, beispielsweise durch Abschleiffen. Ebenfalls in dieser Ebene liegen Kontaktierungsflächen 31 der Kontaktierungselemente 3. Die Oberflächen, auf welchen anschliessend ein Draht oder eine Elektrode eines Halbleiterelements befestigt werden, insbesondere die Kontaktierungsflächen 31 sowie die Oberfläche der zweiten Metallisierung 22, müssen entsprechend vorbehandelt werden.

Von der Isolierschicht 51 wird dabei insbesondere die beim Giessen unvermeidlich erzeugte Giesshaut entfernt, welche zwischen Bauteil und Giessform eindringende Giessmasse enthält und je nach Anpressdruck und Oberflächenbeschaffung der Teile sehr dünn, beispielsweise wenige µm, sein kann.

Dank der Anordnung in einer Ebene kann die Oberflächenpräparation der Kontaktierungsflächen 31, der zweiten Metallisierung 22 sowie der Isolierschicht 51 gemeinsam, mit einem Werkzeug und in einem Arbeitsschritt vorgenommen werden. Dadurch lassen sich die Verarbeitungskosten erheblich reduzieren.

Durch die absolut flache Arbeitsoberfläche lassen sich zudem anschliessend auf einfache Weise Oberflächenveränderungen vornehmen, beispielsweise die Veredelung oder Konservierung der Kontaktierungsflächen 31.

Ebenfalls begünstigt von der flachen Arbeitsoberfläche ist der nächste Verfahrensschritt gemäss Fig. 3, das Aufbringen der Halbleiterelemente 6 auf der zweiten Metallisierung 22. Die Halbleiterelemente 6 werden beispielsweise auf die Metallisierung gelötet oder mittels Nieder-Temperatur-Verbindung befestigt.

Anschliessend werden die Halbleiterelemente 6 untereinander und mit den Kontaktierungsflächen 31 elektrisch leitend verbunden. Beispielsweise mittels einfachen Kontaktierungsdrahtverbindungen 7.

Anschliessend werden die bis zu diesem Zeitpunkt im wesentlichen flach geformten Kontaktierungselemente 3 derart gebogen, dass ein Kontaktierungsstück 32 senkrecht zur Oberfläche der Isolierschicht 51 absteht. Die Kontaktierungselemente 3 sind entsprechend vorbereitet, mit einer Sollbiegestelle, welche den Bereich der Kontaktierungsflächen 31 von dem Kontaktierungsstück trennt. Die Kontaktierungselemente sind aus Metallblech gefertigt und ihre Grösse und Dicke sind den zu leitenden Strömen angepasst. Das Kontaktierungselement umfasst, wie aus den Figuren ersichtlich ist, einen unteren Bereich der unter einen oberen Bereich gefaltet ist. Der obere Bereich umfasst Kontaktierungsfläche 31 und Kontaktierungsstück 32. Da lediglich der obere Bereich auf dem Strompfad liegt, dient der untere Bereich als Feldabschirmung. Die Ecken und Ränder der Kontaktierungselemente, insbesondere des unteren Bereichs sind vorteilhafterweise abgerundet, um Feldüberhöhungen zu vermeiden. Der untere Bereich ist vom oberen Bereich mechanisch entkoppelt, der Bereich der Faltung ist frei von mechanischer Spannung, welche sich negativ auf die Isolierschicht, bzw. deren Isoliereigenschaft auswirken könnte. Selbst beim Anheben des Kontaktierungsstücks 32 wird somit dieser dielektrisch heikle Bereich nicht beeinträchtigt. Werden die Kontaktierungselemente aus Blech gestanzt, beispielsweise aus versilbertem Kupferblech, so ergibt sich durch das Stanzen eine leicht abgerundete Oberfläche, welche, bei entsprechender Anordnung des Blechs mit aussenliegender Rundung, im Bereich der Faltung zur Reduktion des elektrischen Feldes beitragen kann.

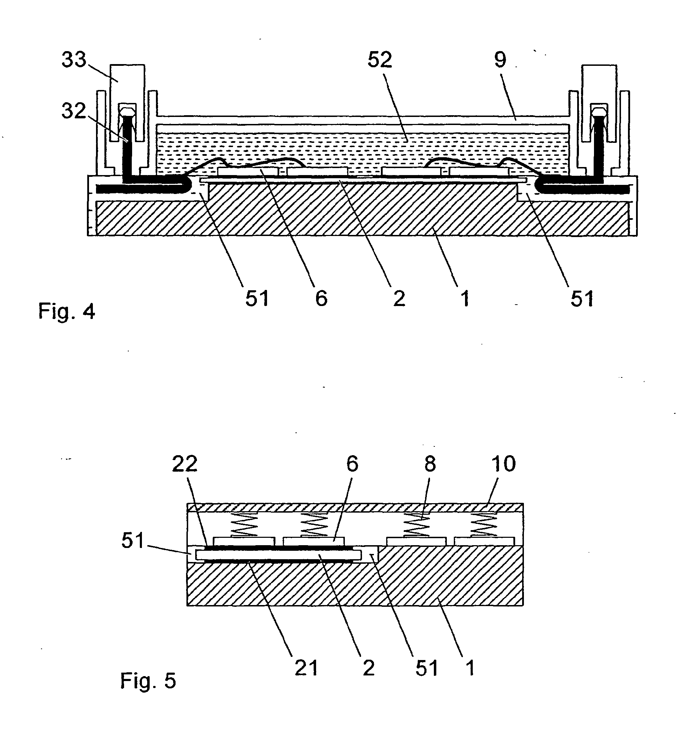

Anschliessend wird das Halbleitermodul mit einem Gehäusedeckel 9 versehen, wie in Fig. 4 dargestellt. Zudem wird der Hohlraum im Innern des Gehäuses wie bei herkömmlichen Halbleitermodulen mit einem Silikongel 52 ausgefüllt.

Die senkrecht abstehenden Kontaktierungsstücke 32, welche durch den Gehäusedeckel 9 aus dem Halbleitermodul geführt sind, werden mittels Kontaktierungssteckern 33 kontaktiert.

Zur Herstellung eines erfindungsgemässen Halbleitermoduls in einer zweiten Ausführungsform gemäss Fig. 5 wird das selbe erfindungsgemässe Verfahren angewandt.

Das Isolationselement 2 wird dabei im ersten Schritt in einer Vertiefung in dem Basiselement 1 angeordnet und am Basiselement befestigt.

Anschliessend werden Basiselement 1 und Isolationelement 2, mit oder ohne Kontaktierungselemente, in die Gussform gebracht und entsprechende Hohlräume zwischen Basiselement und Isolationselement mit elektrisch isolierendem Material ausgefüllt.

Wie in Fig. 5 dargestellt, sind die Oberflächen der zweiten Metallisierung 22, des Basiselements 1 sowie der Isolierschicht 51 in einer gemeinsamen Ebene. Da herkömmliche Standard-Substrate, welche als Isolationselement vorzugsweise verwendet werden, den Anforderungen an die Flachheit für den Einsatz in einem Press-Pack Modul nicht genügen, müssen diese maschinell behandelt werden, beispielsweise durch Fräsen oder Schleifen. Das Präzisionsfräsen kann dank der Anordnung mit einer gemeinsamen Oberfläche bei der Herstellung des erfindungsgemässen Halbleitermoduls mit dem Abfräsen der Isolierschicht verbunden und in einem Schritt durchgeführt werden. Neben der bereits erwähnten Erleichterung der Montage der Halbleiterelemente ermöglicht diese Anordnung weiter die Verwendung von einheitlichen Kontaktstempeln 8, welche Kontaktfedern umfassen und für genügend Anpresskraft auf die Halbleiterelemente 6 sorgen.

### Bezugszeichenliste

- 1: Basiselement
- 2: Isolationselement, Substrat
- 21, 22: Metallisierungen
- 3: Kontaktierungselement
- 31: Kontaktierungsfläche
- 32: Kontaktierungsstück
- 33: Kontaktierungsstecker
- 41, 42: Gussform
- 43: Einlassöffungen
- 44: Hohlraum
- 51: Isolierschicht
- 52: Isolationsgel
- 6: Halbleiterelemente, Chip
- 7: Kontaktierungsdrähte
- 8: Kontaktstempel
- 9: Gehäuse
- 10: Deckelplatte

## Patentansprüche

1. Halbleitermodul mit
- einem Basiselement (1),
- mindestens einem Isolationselement (2), welches mit einer ersten von zwei auf gegenüberliegenden Oberflächen des Isolationselements angeordneten Metallisierungen (21) auf dem Basiselement (1) aufliegt, und
- mit mindestens einem auf der zweiten der zwei Metallisierungen (22) angeordneten Halbleiterelement (6), wobei
- im Randbereich des Isolationselements (2) eine elektrisch isolierende Schicht (51) angeordnet ist,
**dadurch gekennzeichnet, dass**
- mindestens ein Kontaktierungselement (3) zum Kontaktieren des mindestens einen Halbleiterelements (6) in die Isolierschicht (51) eingelassen ist, wobei das Kontaktierungselement (3) durch die Isolierschicht (51) von den Metallisierungen (21, 22) und/ oder dem Basiselement (1) elektrisch isoliert ist, und dass
- das Kontaktierungselement (3) eine kontaktierbare Fläche (31) aufweist, welche mit der Oberfläche der Isolierschicht (51) und der Oberfläche der zweiten Metallisierung (22) eine gemeinsame plane Oberfläche bildet.

2. Halbleitermodul nach Anspruch 1, **dadurch gekennzeichnet, dass**
- das Kontaktierungselement (3) ein bewegbares Kontaktierstück (32) umfasst, dass
- die Oberfläche des Kontaktierstücks (32) im vormontierten Zustand in einer Ebene mit der Oberfläche der Isolierschicht (51) liegt, und dass
- das Kontaktierstück (32) im montierten Zustand im wesentlichen senkrecht zur Oberfläche der Isolierschicht (51) steht.

3. Halbleitermodul nach einem der Ansprüche 1 oder 2, **dadurch gekennzeichnet, dass**
- das Basiselement (1) eine Oberflächenvertiefung aufweist, dass
- das Isolationselement (2) in der Vertiefung angeordnet ist, wobei die zweite Metallisierung (22) durch die Isolierschicht (51) von dem Basiselement (1) elektrisch isoliert ist, und dass
- die Oberfläche der Isolierschicht (51) mit der Oberfläche der zweiten Metallisierung (22) und der Oberfläche des Basiselements (1) eine gemeinsame plane Oberfläche bildet.

4. Halbleitermodul nach Anspruch 3, **dadurch gekennzeichnet, dass**
- auf der Oberfläche des Basiselements (1) mindestens ein Halbleiterelement (6) angeordnet ist.

5. Halbleitermodul nach einem der Ansprüche 1 bis 4, **dadurch gekennzeichnet, dass**
- die Isolierschicht (51) aus einem Material besteht, welches ohne zu deformieren wenige Sekunden, insbesondere 5 bis 10 Sekunden auf über 200° C, insbesondere über 220° C erhitzt werden kann.

6. Verfahren zum Herstellen eines Halbleitermoduls, mit folgenden Verfahrensschritten:
- mindestens ein Isolationselement (2) wird mit einer ersten von zwei auf gegenüberliegenden Oberflächen des Isolationselements angeordneten Metallisierungen (21) auf einem Basiselement (1) oder in einer Oberflächenvertiefung des Basiselements (1) befestigt,
- Halbleiterelemente (6) werden auf der zweiten der beiden Metallisierungen (22) und/ oder, falls das Isolationselement (2) in einer Vertiefung angeordnet ist, auf der Oberfläche des Basiselements (1) befestigt,
- Haupt- und/ oder Steueranschlüsse der Halbleiterelemente (6) werden mit Drahtverbindungen (7) oder anderen elektrischen Leitern kontaktiert und mit Kontaktierungsflächen (31) von Kontaktierungselementen (3) verbunden, **dadurch gekennzeichnet, dass** bevor die Halbleiterelemente (6) befestigt werden,
- Basiselement (1) und Isolationselement (2) zusammen mit den Kontaktierungselementen (3) in eine Gussform (41, 42) gebracht werden,
- eine Isolierschicht (51) durch Ausfüllen des nicht durch Basiselement (1), Isolationselement (2) oder Kontaktierungselement (3) beanspruchten Volumens der Gussform (44) mit einem elektrisch isolierenden Material geformt wird,
- die Isolierschicht (51) gehärtet und anschliessend von der Isolierschicht (51) soviel Material abgetragen wird, dass die Oberfläche der Isolierschicht (51) mit der Oberfläche der zweiten der zwei Metallisierung (22), mit Kontaktierungsflächen (31) der Kontaktierungselemente (3), sowie, falls das Isolationselement (2) in einer Vertiefung angeordnet ist, mit der Oberfläche des Basiselements (1) eine gemeinsame plane Oberfläche bildet,
und, dass nachdem die Halbleiterelemente (6) befestigt worden sind,
- bewegliche Kontaktierungsstücke (32) der Kontaktierungselemente (3) senkrecht zur Oberfläche der Isolierschicht (51) aufgerichtet werden.

7. Verfahren nach Anspruch 6, **dadurch gekennzeichnet, dass**
- die Gussform (41, 42) vor dem Auffüllen mit dem elektrisch isolierenden Material zumindest teilweise evakuiert wird, und dass
- das isolierende Material blasenfrei und homogen in das freie Volumen der Gussform gefüllt wird.

## Claims

1. Semiconductor module with
- a base element (1),
- at least one insulating element (2), which rests on the base element (1) by a first of two metallizations (21) arranged on opposite surfaces of the insulating element, and
- with at least one semiconductor element (6) arranged on the second of the two metallizations (22),
- an electrically insulating layer (51) being arranged in the edge region of the insulating element (2),
**characterized in that**
- for the contacting of the at least one semiconductor element (6), at least one contacting element (3) is recessed into the insulating layer (51), the contact element (3) being electrically insulated from the metallizations (21, 22) and/or the base element (1) by the insulating layer (51), and **in that**
- the contacting element (3) has a contactable area (31), which forms a common planar surface with the surface of the insulating layer (51) and the surface of the second metallization (22).

2. Semiconductor module according to Claim 1, **characterized in that**
- the contacting element (3) comprises a movable contacting piece (32), **in that**
- in the pre-assembled state, the surface of the contacting piece (32) lies in a plane with the surface of the insulating layer (51), and **in that**
- in the assembled state, the contacting piece (32) is substantially perpendicular in relation to the surface of the insulating layer (51).

3. Semiconductor module according to one of Claims 1 or 2, **characterized in that**
- the base element (1) has a surface depression, **in that**
- the insulating element (2) is arranged in the depression, the second metallization (22) being electrically insulated from the base element (1) by the insulating layer (51), and **in that**
- the surface of the insulating layer (51) forms a common planar surface with the surface of the second metallization (22) and the surface of the base element (1).

4. Semiconductor module according to Claim 3, **characterized in that**
- at least one semiconductor element (6) is arranged on the surface of the base element (1).

5. Semiconductor module according to one of Claims 1 to 4, **characterized in that**
- the insulating layer (51) consists of a material which can be heated for a few seconds, in particular 5 to 10 seconds, to above 200°C, in particular above 220°C, without deforming.

6. Method of producing a semiconductor module, with the following method steps:
- at least one insulating element (2) is attached on a base element (1) or in a surface depression of the base element (1) by a first of two metallizations (21) arranged on opposite surfaces of the insulating element,
- semiconductor elements (6) are attached on the second of the two metallizations (22) and/or, if the insulating element (2) is arranged in a depression, on the surface of the base element (1),
- main and/or control terminals of the semiconductor elements (6) are contacted by wire connections (7) or other electrical conductors and connected to contacting areas (31) of contacting elements (3),
**characterized in that**, before the semiconductor elements (6) are attached,
- the base element (1) and insulating element (2) together with the contacting elements (3) are introduced into a casting mold (41, 42),
- an insulating layer (51) is formed by filling the volume of the casting mold (44) not taken up by the base element (1), insulating element (2) or contacting element (3) with an electrically insulating material,
- the insulating layer (51) is cured and sufficient material is subsequently removed from the insulating layer (51) that the surface of the insulating layer (51) forms a common planar surface with the surface of the second of the two metallizations (22), with contacting areas (31) of the contacting elements (3) and, if the insulating element (2) is arranged in a depression, with the surface of the base element (1),
- and **in that**, after the semiconductor elements (6) have been attached,
- movable contacting pieces (32) of the contacting elements (3) are arranged upright, perpendicularly in relation to the surface of the insulating layer (51).

7. Method according to Claim 6, **characterized in that**
- the casting mold (41, 42) is at least partially evacuated before filling with the electrically insulating material, and **in that**
- the actuating material is filled into the free volume of the casting mold without bubbles and homogeneously.

## Revendications

1. Module semi-conducteur comprenant :
- un élément de base (1),
- au moins un élément d'isolation (2) qui prend appui sur l'élément de base (1) par une première de deux métallisations (21) disposées sur les surfaces opposées de l'élément d'isolation, et
- au moins un élément semi-conducteur (6) disposé sur la deuxième des deux métallisations (22), dans lequel
- une couche (51) électriquement isolante est disposée dans la région périphérique de l'élément d'isolation (2),
**caractérisé en ce que**
- au moins un élément de contact (3) destiné à venir au contact de l'au moins un élément semi-conducteur (6) est encastré dans la couche isolante (51), dans lequel l'élément de contact (3) est électriquement isolé par la couche isolante (51) des métallisations (21, 22) et/ou de l'élément de base (1), et **en ce que** l'élément de contact (3) présente une surface (31) avec laquelle un contact peut être établi, qui forme une surface plane commune avec la surface de la couche isolante (51) et la surface de la deuxième métallisation (22).

2. Module semi-conducteur selon la revendication 1, **caractérisé en ce que** :
- l'élément de contact (3) comprend une pièce de contact (32) mobile, **en ce que**
- la surface de la pièce de contact (32), à l'état pré-monté, se situe au même niveau que la surface de la couche d'isolation (51), et **en ce que**
- la pièce de contact (32), à l'état monté, est positionnée sensiblement perpendiculairement à la surface de la couche d'isolation (51).

3. Module semi-conducteur selon l'une des revendications 1 ou 2, **caractérisé en ce que** :
- l'élément de base (1) présente un évidement de surface, **en ce que**
- l'élément d'isolation (2) est disposé dans l'évidement, la deuxième métallisation (22) étant électriquement isolée de l'élément de base (1) par la couche isolante (51), et **en ce que**
- la surface de la couche isolante (51) forme avec la surface de la deuxième métallisation (22) et la surface de l'élément de base (1) une surface plane commune.

4. Module semi-conducteur selon la revendication 3, **caractérisé en ce que** :
- au moins un élément semi-conducteur (6) est disposé sur la surface de l'élément de base (1).

5. Module semi-conducteur selon les revendications 1 à 4, **caractérisé en ce que** :
- la couche isolante (51) est constituée d'un matériau qui peut être chauffé à plus de 200°C, notamment à plus de 220°C sans se déformer pendant quelques secondes, notamment de 5 à 10 secondes.

6. Procédé destiné à la fabrication d'un module semi-conducteur, comprenant les étapes suivantes :
- au moins un élément d'isolation (2) est fixé, par une première de deux métallisations (21) disposées sur les surfaces opposées de l'élément d'isolation, à un élément de base (1) ou dans un évidement de surface de l'élément de base (1),
- des éléments semi-conducteurs (6) sont fixés à la deuxième des deux métallisations (22) et/ou, au cas où l'élément d'isolation (2) est disposé dans un évidement, à la surface de l'élément de base (1),
- des bornes principales et/de commande des éléments semi-conducteurs (6) sont mises en contact avec des soudures par fil (7) ou d'autres conducteurs électriques et sont reliées à des surfaces de contact (31) des éléments de contact (3),
**caractérisé en ce que**, avant que les éléments semi-conducteurs (6) soient fixés,
- l'élément de base (1) et l'élément d'isolation (2) sont introduits dans un moule (41, 42) en association avec les éléments de contact (3),
- une couche isolante (51) est formée par remplissage du volume du moule (44) non occupé par l'élément de base (1), par l'élément d'isolation (2) ou par l'élément de contact (3) avec un matériau électriquement isolant,
- la couche isolante (51) est durcie, puis une quantité de matériau telle que la surface de la couche isolante (51) forme une surface plane commune avec la surface de la deuxième des deux métallisations (22), avec les surfaces de contact (31) des éléments de contact (3), ainsi que, au cas où l'élément d'isolation (2) est disposé dans un évidement, avec la surface de l'élément de base (1), est retirée de la couche isolante (51),
et **en ce qu'**après que les éléments semi-conducteurs (6) ont été fixés,
- des pièces de contact (32) mobiles des éléments de contact (3) sont redressées perpendiculairement à la surface de la couche isolante (51).

7. Procédé selon la revendication 6, **caractérisé en ce que** :
- le moule (41, 42) est vidé au moins partiellement avant d'être rempli du matériau électriquement isolant, et **en ce que**
- le matériau isolant est introduit dans le volume libre du moule en l'absence de bulles et de manière homogène.
